# EUROPEAN PATENT APPLICATION

(11) **EP 4 131 336 A1**
(43) Date of publication of application: **08.02.2023**
(21) Application number: 21779422.1
(22) Date of filing: 01.04.2021
(51) Int. Cl.: H01L 21/02

(54) **COMPOSITE SUBSTRATE AND PRODUCTION METHOD THEREFOR**

(30) Priority: 02.04.2020 JP 2020067086
(71) Applicant: Shin-Etsu Chemical Co., Ltd., Tokyo 100-0005 (JP)
(72) Inventor: AKIYAMA, Shoji, Annaka-shi, Gunma 379-0195 (JP); TANNO, Masayuki, Annaka-shi, Gunma 379-0195 (JP); SHIRAI, Shozo, Annaka-shi, Gunma 379-0195 (JP)
(74) Representative: HGF
(86) International application number: PCT/JP2021/014151
(87) International publication number: WO 2021/201219

(57) **Abstract**

A composite substrate is resistant to the development of cracks, thereby not having deteriorating properties even when exposed to high-temperatures or low temperatures, and a method is provided for producing the composite substrate. The composite substrate 10 of the present invention has a supporting substrate 2, a stress relaxing interlayer 3, and an oxide single-crystal thin film 1 stacked in the listed order. The stress relaxing interlayer 3 has a thermal expansion coefficient between that of the supporting substrate 2 and that of the oxide single-crystal thin film 1.

## Description

### TECHNICAL FIELD

The present invention relates to a composite substrate and to a production method therefor.

### BACKGROUND ART

To expand the application range of conventional functional materials (such as semiconductors and oxide single-crystals), there has recently been extensive development of bonding substrates of different kinds, thereby achieving higher performance. In the fields of semiconductors, Silicon on Insulator (SOI) and the like are known, while in the fields of oxide single-crystals, composite substrates having improved temperature properties are reported which are obtained by bonding an oxide single-crystal substrate such as lithium tantalate (LiTaOs abbreviated as LT) or lithium niobate (LiNbO₃ abbreviated as LN) to sapphire or the like, and thinning the resulting oxide single-crystal substrate.

There also have been attempts to provide an interlayer between a functional thin film and a supporting substrate for the purpose of separation. Specifically, materials such as SiO₂ having high insulation properties, having less high-frequency loss (low dielectric loss), and that are easily processable (easily planarizable) are often used as a material of the interlayer. In order to satisfy the aforesaid properties, a metal oxide (such as TiO₂, Ta₂O₅, Nb₂O₅, or ZrO₂ as well as SiO₂) is frequently selected for the interlayer. A composite substrate (for example, LT on SiO₂ on Si substrate) having an interlayer as described above often has excellent properties such as excellent high-frequency properties (low high-frequency loss, improved linearity, and reduced crosstalk) because its active layer is thin.

### SUMMARY OF THE INVENTION

### PROBLEM TO BE SOLVED BY THE INVENTION

The aforesaid composite substrate obtained by bonding substrates of different kinds, however, has a drawback. Compared with silicon, glass, and sapphire generally used as a material of a supporting substrate, an oxide single-crystal has a considerably large thermal expansion coefficient (for example, that of LT or LN is about 15 to 16 ppm). Those of silicon, glass, and sapphire are, on the other hand, about 2.5 ppm, 0.5 ppm, and 7.5 ppm, respectively. When a device using a supporting substrate having an oxide single-crystal layer thereon is exposed to high temperatures or low temperatures in an actual environment, it inevitably has deteriorated properties because a large stress is imposed on the oxide single-crystal layer, and microcracks extending from the interface gradually break the oxide single-crystal layer. Such a problem is due to the structure itself formed by stacking an oxide single-crystal thin film on a supporting substrate having a small expansion coefficient in order to have improved temperature properties.

With the aforesaid problem in mind, objects of the present invention are to provide a composite substrate that will not develop cracks, thereby not having deteriorating properties even when exposed to high temperatures or low temperatures, and to provide a method for producing the composite substrate.

### MEANS FOR SOLVING THE PROBLEM

To achieve the aforesaid object, the present invention provides, as one aspect thereof, a method for producing a composite substrate having a supporting substrate, a stress relaxing interlayer, and an oxide single-crystal thin film stacked in the listed order, including the steps of: forming a stress relaxing interlayer between a supporting substrate and an oxide single-crystal substrate, having a thermal expansion coefficient between that of the supporting substrate and that of the oxide single-crystal substrate; bonding the supporting substrate and the oxide single-crystal substrate to each other with the stress relaxing interlayer therebetween to obtain a laminate; and thinning the oxide crystal substrate of the laminate into an oxide crystal thin film.

In another aspect, the method for producing a composite substrate according to the present invention is a method for producing a composite substrate having a supporting substrate, an interlayer, a stress relaxing interlayer, and an oxide single-crystal thin film stacked in the listed order by using a bonding method so as to satisfy the following inequality when their thermal expansion coefficients are compared: the interlayer < the stress relaxing interlayer < the oxide single-crystal thin film.

The interlayer preferably includes SiO₂, SiON, or SiN.

The interlayer is preferably formed by a chemical vapor deposition method (CVD method) or a physical vapor deposition method (PVD method).

The stress relaxing interlayer preferably includes SiN, SiC, AlN, Al₂O₃, Y₂O₃, TiO₂, or ZrO₂.

The oxide single-crystal substrate preferably includes lithium tantalate (LT) or lithium niobate (LN).

The stress relaxing interlayer is preferably formed by a chemical vapor deposition method (CVD method) or a physical vapor deposition method (PVD method).

The oxide crystal substrate of the laminate may be thinned by grinding, polishing, or combination thereof.

The production method may further include a step of subjecting the surface of the oxide single-crystal substrate to be bonded to ion implantation treatment to form an ion implantation layer in the oxide single-crystal substrate; and the oxide crystal substrate of the laminate may be thinned by leaving the ion implantation layer as an oxide single-crystal thin film and releasing the remaining portion of the oxide single-crystal substrate from the laminate.

A further aspect of the present invention is a composite substrate having a supporting substrate, a stress relaxing interlayer, and an oxide single-crystal thin film stacked in the listed order, wherein the stress relaxing interlayer has a thermal expansion coefficient between that of the supporting substrate and that of the oxide single-crystal thin film.

Yet another further aspect of the present invention is a composite substrate having a supporting substrate, an interlayer, a stress relaxing interlayer, and an oxide single-crystal thin film stacked in the listed order, wherein the stress relaxing interlayer has a thermal expansion coefficient between that of the interlayer and that of the oxide single-crystal thin film.

The interlayer preferably includes SiO₂, SiON, or SiN.

The stress relaxing interlayer preferably includes SiN, SiC, AlN, Al₂O₃, Y₂O₃, TiO₂, or ZrO₂.

The oxide single-crystal substrate preferably includes lithium tantalate (LT) or lithium niobate (LN).

### EFFECTS OF THE INVENTION

Thus, according the present invention, interposing, between an oxide single-crystal thin film and a supporting substrate, a stress relaxing interlayer made of a material having a thermal expansion coefficient less than that of the oxide single-crystal thin film and greater than that of the supporting substrate makes it possible to reduce a stress imposed on the interface of the oxide single-crystal thin film, resulting in no cracks, and preventing deterioration of properties when temperature changes.

### BRIEF DESCRIPTION OF THE DRAWINGS

FIG. 1 is a cross-sectional view schematically showing one embodiment of the composite substrate according to the present invention.
FIG. 2 is a graph showing the respective thermal expansion coefficients of typical materials to be used for the composite substrate according to the present invention.
FIG. 3 is a cross-sectional view schematically showing another embodiment of the composite substrate according to the present invention.
FIG. 4 is a schematical flow chart explaining one embodiment of the method for producing a composite substrate according to the present invention.
FIG. 5 is a schematical flow chart explaining another embodiment of the method for producing a composite substrate according to the present invention.
FIG. 6 is a schematical flow chart explaining a further embodiment of the method for producing a composite substrate according to the present invention.

### MODE FOR CARRYING OUT THE INVENTION

The embodiments of the composite substrate and production method therefor according to the present invention will hereinafter be described with reference to the attached drawings, but the scope of the present invention is not limited thereto.

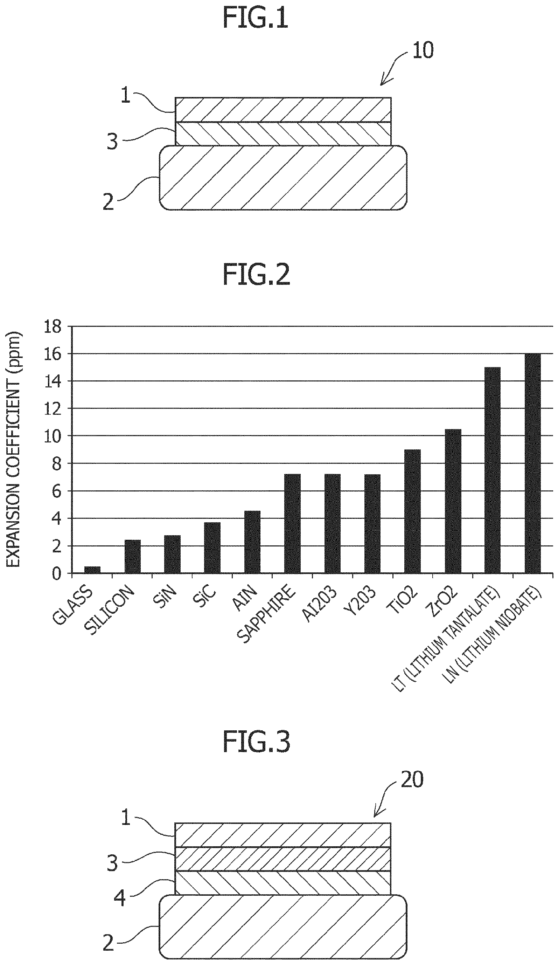

A composite substrate 10 of the present embodiment has, as shown in FIG. 1, a supporting substrate 2, a stress relaxing interlayer 3, and an oxide single-crystal thin film 1 stacked in the listed order.

As the oxide single-crystal thin film 1, a piezoelectric single-crystal is preferred and, for example, a compound composed of lithium and tantalum or niobium, each a metallic element, and oxygen is preferred. Examples of such a compound include lithium tantalate (LiTaO₃ abbreviated as "LT") and lithium niobate (LiNbO₃ abbreviated as "LN"). The thickness of the oxide single-crystal thin film 1 is, for example, preferably 0.1 to 30 µm.

The supporting substrate 2 is not particularly limited as long as it is an insulating substrate ordinarily used for a composite substrate. Examples thereof include a silicon substrate, a glass substrate, and a sapphire substrate. The supporting substrate 2 may be used in the form of a wafer. The size of the wafer is, for example, preferably 2 to 12 inches in diameter and 100 to 2,000 µm in wafer thickness.

For the stress relaxing interlayer 3, a material having a thermal expansion coefficient less than that of the oxide single-crystal thin film 1 and greater than that of the supporting substrate 2 is used. This layer is called a "stress relaxing interlayer" in the present invention because interposition of a layer of a material having such a thermal expansion coefficient between the oxide single-crystal thin film 1 and the supporting substrate 2 makes it possible to reduce stress imposed on the interface of the oxide single-crystal thin film 1 and prevent deterioration thereof when temperature changes.

The respective thermal expansion coefficients of typical materials used for the composite substrate are shown in FIG. 2. The thermal expansion coefficients of SiN, SiC, AlN, Al₂O₃, Y₂O₃, TiO₂, and ZrO₂, among these materials, lie between that of LT or LN of the oxide single-crystal thin film 1 and that of silicon or glass of the supporting substrate 2 so that they are preferred as a material of the stress relaxing interlayer 3. The thickness of the stress relaxing interlayer 3 is, for example, preferably 0.1 to 5.0 µm.

The structure of the composite substrate in the present invention is not limited to that of the composite substrate 10, but may be, for example, that shown in FIG. 3. The composite substrate 20 of another embodiment has, as shown in FIG. 3, a supporting substrate 2, an interlayer 4, a stress relaxing interlayer 3, and an oxide single-crystal thin film 1 stacked in the listed order.

A material for the interlayer 4 may be that ordinarily used for an interlayer of a composite substrate and a material having a thermal expansion coefficient less than that of the oxide single-crystal thin film 1 and greater than that of the stress relaxing interlayer 3 is used. Examples of such a material include SiO₂, SiON, and SiN. When the interlayer 4 is composed of such a material, a stress on the interface of the oxide single-crystal thin film 1 which will otherwise occur by temperature change can be reduced and deterioration can be prevented as described above by the stress relaxing interlayer 3. In other words, in the composite substrate 20 of another embodiment, a material having a thermal expansion coefficient less than that of the oxide single-crystal thin film 1 and greater than that of the interlayer 4 is used for the stress relaxing interlayer 3.

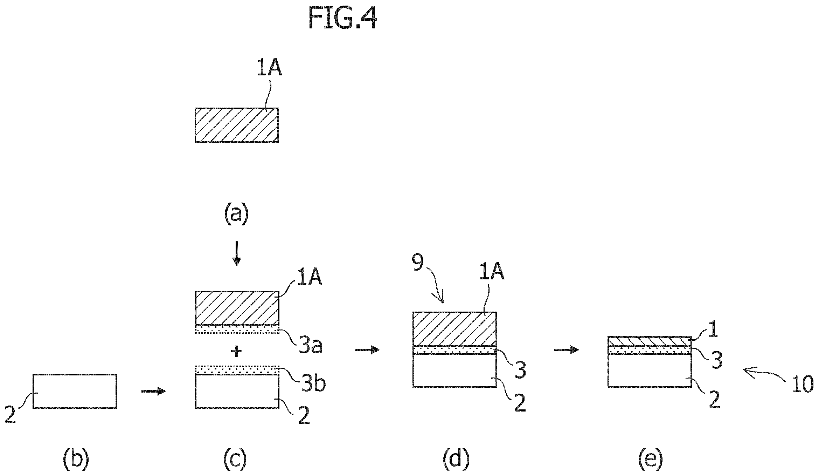

Next, a method for producing a composite substrate according to the present embodiment will be described. As shown in FIG. 4, it includes a step of preparing an oxide single-crystal substrate 1A ((a) in FIG. 4), a step of preparing a supporting substrate 2 ((b) in FIG. 4), a step of forming a stress relaxing interlayer 3 on the oxide single-crystal substrate 1 and the supporting substrate 2 ((c) in FIG. 4), a step of bonding the oxide single-crystal substrate 1 and the supporting substrate 2 to each other via the stress relaxing interlayer 3 therebetween ((d) in FIG. 4), and a step of thinning the oxide single-crystal substrate of the laminate 4 obtained by the bonding and thereby obtaining a composite substrate 10 ((e) in FIG. 4). Each of these steps will next be described specifically. The method described below is only an example. The stress relaxing interlayer 3 may be formed on either substrate by any method, and the bonding may be performed at any surface.

The oxide single-crystal substrate 1A prepared in the step (a) is a substrate which will be the oxide single-crystal thin film 1 of the composite substrate 10 shown in FIG. 1. The oxide single-crystal has already been described above so that a description thereof is omitted here. The oxide single-crystal substrate 1 may be used in the form of a wafer. The size of the wafer is not particularly limited, and for example, it may have a diameter of 2 to 8 inches and a wafer thickness of 100 to 1000 µm.

The supporting substrate 2 to be prepared in the step (b) is the supporting substrate 2 of the composite substrate 10 shown in FIG. 1. It has already been described above so that a description thereof is omitted here.

The surface of the oxide single-crystal substrate 1 to be bonded, or the surface of the supporting substrate 2 to be bonded, is not necessarily a mirrored surface because the surface of the oxide single-crystal substrate 1 and the surface of the supporting substrate 2 to be bonded are bonded to each other via the stress relaxing interlayer 3.

Next, as shown in the step (c) in FIG. 4, stress relaxing interlayers 3a and 3b are formed on the surface of the oxide single-crystal substrate 1 to be bonded and the surface of the supporting substrate 2 to be bonded. The material of the stress relaxing interlayer 3 have already been described above so that a description thereof is omitted here.

Examples of a method for forming the stress relaxing interlayer 3 include a chemical vapor deposition method (CVD method) and a physical vapor deposition method (PVD method). Examples of the CVD method include a thermal CVD method, a plasma CVD method, and a photo-CVD method. Examples of the PVD method include a vapor deposition method, an ion plating method, and a sputtering method. By using such a CVD or PVD method under known conditions for forming a film such as a silicon nitride film, the stress relaxing interlayer 3 can be formed on the surface of the oxide single-crystal substrate 1 or the supporting substrate 2 to be bonded.

According to the description in the step (c) in FIG. 4, the stress relaxing interlayers 3a and 3b are formed on the respective surfaces of the oxide single-crystal substrate 1 and the supporting substrate 2 to be bonded, but the present invention is not limited to this. For example, similar effects can be obtained when the stress relaxing interlayer 3a may be formed only on the surface of the oxide single-crystal substrate 1 to be bonded or when the stress relaxing interlayer 3b may be formed only on the surface of the supporting substrate 2 to be bonded. As already described above, it may be freely chosen on which substrate the stress relaxing interlayer 3 is formed, how it is formed, and on which surface the bonding is performed. This does not have any influence on the effects of the present invention.

Then, as shown in the step (d) in FIG. 4, the oxide single-crystal substrate 1 and the supporting substrate 2 are bonded to each other via the stress relaxing interlayer 3 to obtain a laminate 4. It is to be noted that prior to bonding, both the surfaces of the oxide single-crystal substrate 1 and the supporting substrate 2 to be bonded are subjected to surface activation treatment. The surface activation treatment is not particularly limited as long as it can activate the surface to be bonded and examples include a plasma activation treatment, a vacuum ion beam method, an ozone water treatment method, and a UV ozone treatment method. As the atmosphere for the surface activation treatment, an inert gas such as nitrogen and argon, or oxygen, may be used either alone or in combination.

The laminate 4 thus obtained by bonding the oxide single-crystal substrate 1 and the supporting substrate 2 to each other via the stress relaxing interlayer 3 may be subjected to thermal treatment. The bond strength between them can be increased by this treatment.

Then, as shown in the step (e) in FIG. 4, the oxide single-crystal substrate 1A of the laminate 4 is thinned. As a result, the composite substrate 10 having the oxide single-crystal thin film 1 formed on the supporting substrate 2 via the stress relaxing interlayer 3 can be obtained.

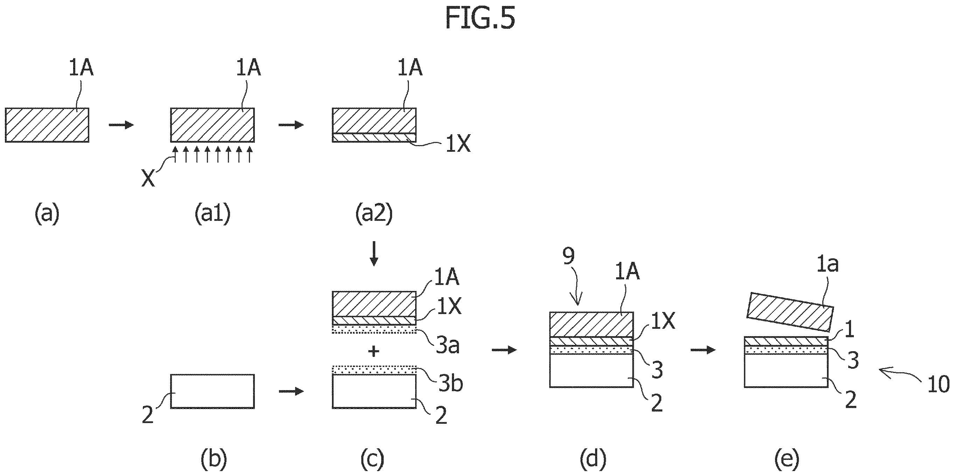

The method for producing the composite substrate 10 was described referring to FIG. 4. The present invention is not limited thereto, and many modifications such as switching of the order of the aforementioned steps and addition of another step may be performed. For example, the composite substrate 10 may be produced by the method shown in FIG. 5.

As shown in FIG. 5, the method for producing a composite substrate according to this other embodiment includes a step of preparing an oxide single-crystal substrate 1A ((a) in FIG. 5), a step of subjecting the oxide single-crystal substrate 1A to ion implantation treatment X ((a1) in FIG. 5), a step of thereby forming an ion implantation layer 1X on the oxide single-crystal substrate 1 ((a2) in FIG. 5), a step of preparing a supporting substrate 2 ((b) in FIG. 5), a step of forming a stress relaxing interlayer 3 on the oxide single-crystal substrate 1A and the supporting substrate 2 ((c) in FIG. 5), a step of bonding the oxide single-crystal substrate 1A and the supporting substrate 2 to each other via the stress relaxing interlayer 3 ((d) in FIG. 5), and a step of releasing a portion 1b of the oxide single-crystal substrate from the laminate 4 thus obtained by the bonding to obtain a composite substrate 10 ((e) in FIG. 5). Each of the newly added steps will next be described specifically. The method described below is only an example. It may be freely chosen on which substrate the stress relaxing interlayer 3 is formed, how it is formed, and on which surface the bonding is performed.

In the step (a1), the surface of the oxide single-crystal substrate 1A to be bonded is subjected to ion implantation treatment A. By this treatment, as shown in the step (a2), an ion implantation layer 1X is formed on the surface of the oxide single-crystal substrate 1A to be bonded. The conditions of the ion implantation treatment follow. For example, when hydrogen atomic ions (H⁺) are used, the dosage is preferably 5.0×10¹⁶ atom/cm² to 2.75×10¹⁷ atoms/cm². When the dosage is less than 5.0×10¹⁶ atoms/cm², embrittlement of the ion implantation layer does not easily occur in later steps. When the dosage exceeds 2.75×10¹⁷ atoms/cm², microcavities may appear on the ion-implanted surface at the time of ion implantation, and the wafer surface becomes irregular, making it difficult to obtain a desired surface roughness. When hydrogen molecular ions (H₂⁺) are used, the dosage is preferably 2.5×10¹⁶ atoms/cm² to 1.37×10¹⁷ atoms/cm².

The accelerating voltage of ions is preferably 50 KeV to 200 KeV The depth of ion implantation can be changed by adjusting the accelerating voltage. The thickness of the ion implantation layer 1X is preferably adjusted to 100 nm to 2,000 nm. The thickness of this ion implantation layer 1X almost corresponds to the thickness of the oxide single-crystal thin film 1 of the composite substrate 10 to be obtained.

Then, in the step (e) in FIG. 5, a portion 1a of the oxide single-crystal substrate is rereleased from the laminate 4 while leaving the ion implantation layer 1X on the side of the stress relaxing interlayer 3. Thus, a composite substrate 10 having the ion implantation layer (oxide single-crystal thin film) 1 formed on the supporting substrate 2 via the stress relaxing interlayer 3 can be obtained. The aforesaid release may be done by giving a mechanical impact with a wedge-shaped blade (not shown in the drawing).

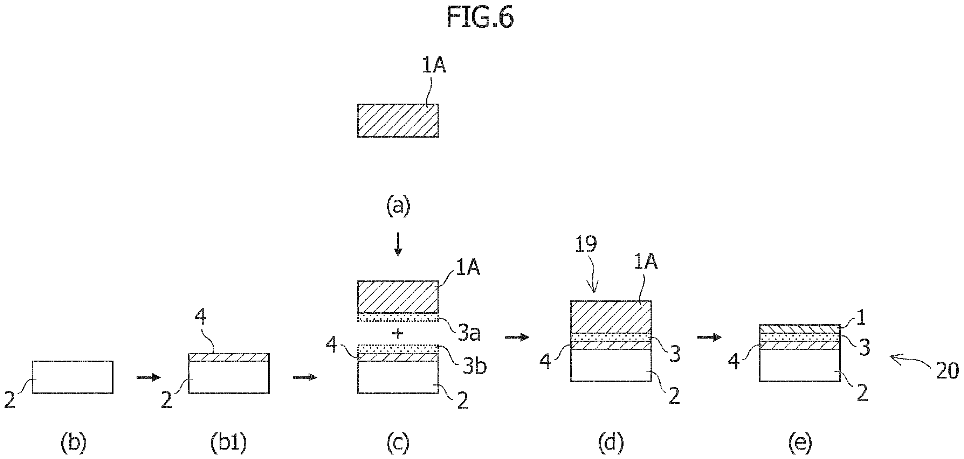

In addition, one embodiment of a method for producing the composite substrate 20 shown in FIG. 3 is shown in FIG. 6. The method for producing the composite substrate shown in FIG. 6 includes a step of preparing an oxide single-crystal substrate 1A ((a) in FIG. 6), a step ((b) in FIG. 6) of preparing a supporting substrate 2, a step of forming an interlayer 4 on the supporting substrate 2 ((b1) in FIG. 6), a step of forming a stress relaxing interlayer 3 on the oxide single-crystal substrate 1A and the interlayer 4 ((c) in FIG. 6), a step of bonding the oxide single-crystal substrate 1A and the supporting substrate 2 having the interlayer 4 to each other via the stress relaxing interlayer 3 ((d) in FIG. 6), and a step of performing grinding, polishing, or the like to thin the oxide single-crystal substrate 1A of the laminate 4 obtained by the bonding and thereby obtaining a composite substrate 20 ((e) in FIG. 6). A newly added step will hereinafter be described in detail. The method shown below is, however, only an example, and it may be freely chosen on which substrate the interlayer 4 or the stress relaxing interlayer 3 is formed, how they are formed, and on which surface the bonding is performed.

As shown in the step (b1) in FIG. 6, the interlayer 4 is formed on the surface of the supporting substrate 2 to be bonded. The material of the interlayer 4 has already been described above so that a description thereof is omitted here. Examples of the method of forming the interlayer 4 include a chemical vapor deposition method (CVD method) and a physical vapor deposition method (PVD method). Examples of the CVD method include a thermal CVD method, a plasma CVD method, and a photo-CVD method. Examples of the PVD method include a vapor deposition method, an ion plating method, and a sputtering method. By using such a CVD or PVD method under known conditions for forming a film such as a silicon oxide film, the interlayer 4 can be formed on the surface of the supporting substrate 2 to be bonded.

### EXAMPLES

Examples and comparative examples will hereinafter be described, but the present invention is not limited to them.

### Example 1

A silicon substrate having a diameter of 150 mm and a lithium tantalate (LT) substrate were bonded to each other while interposing a stress relaxing interlayer composed of each of SiN, SiC, AlN, Al₂O₃, Y₂O₃, TiO₂, and ZrO₂ between the silicon substrate and the lithium tantalate substrate to obtain a laminate. The stress relaxing interlayer was formed on the silicon substrate by a CVD method. The respective surfaces of the silicon substrate and the LT substrate were subjected to plasma activation treatment in advance. The LT substrate of the resulting laminate was then thinned to 6 µm by grinding or polishing to obtain a composite substrate.

A thermal shock test was carried out on the composite substrates thus obtained under the following conditions. The substrates were each moved between a low temperature chamber of -60°C and a high temperature chamber of 170°C and residence time at each temperature was 10 minutes. In the test, a thermal shock chamber ("TSE-12-A", product of ESPEC CORP.) was used. Moving between two chambers was performed for 10 cycles, and then, the resulting composite substrate was taken out from the chamber and was examined for cracks by an exterior inspection system ("BB-Master", product of Kurabo Industries Ltd.). When the composite substrate was examined at five places thereof and a crack was found even at one place, the test on the composite substrate was stopped. When no crack was found, the thermal shock test was continued. The number of cycles at which a crack was found is shown in Table 1 as a test result (LT on Si). In Table 1, the numbers in the parentheses after each material in the column of the stress relaxing interlayer indicate the thermal expansion coefficient (ppm) of the material.

**Table 1**

| Stress relaxing interlayer | LT on Si | LT on sapphire | LT on glass |
|---|---|---|---|
| None | 20 | 50 | 10 |
| SiN (2.8) | 90 | 30 | 50 |
| SiC (3.7) | 120 | 40 | 70 |
| AlN (4.6) | 160 | 40 | 80 |
| Al₂O₃ (7.2) | 140 | 50 | 80 |
| Y₂O₃ (7.2) | 160 | 50 | 80 |
| TiO₂ (9.0) | 270 | 280 | 160 |
| ZrO₂ (10.5) | >300 | >300 | 170 |

The above results have revealed that any of the composite substrates having a stress relaxing interlayer interposed therein have improved reliability compared with those having no stress relaxing interlayer therein. This improvement is presumed to be due to the stress relaxation effect because any of the materials used for the stress relaxing interlayer has a thermal expansion coefficient greater than that (2.5 ppm) of silicon of the supporting substrate and less than that (15 ppm) of LT.

### Example 2

In a manner similar to that of Example 1, except for the use of a sapphire substrate instead of the silicon substrate, a composite substrate was produced, and under conditions similar to those of Example 1, a thermal shock test was carried out. The results are shown in Table 1 (LT on sapphire). These results have revealed that the composite substrate having a stress relaxing interlayer interposed therein has improved reliability only when the thermal expansion coefficient of the stress relaxing interlayer is greater than that (7.5 ppm) of the sapphire.

### Example 3

In a manner similar to that of Example 1 except for the use of a glass substrate instead of the silicon substrate, a composite substrate was produced, and under conditions similar to those of Example 1, a thermal shock test was carried out. The results are shown in Table 1 (LT on glass). These results have revealed that any of the composite substrates having a stress relaxing interlayer interposed therein has improved reliability, which is presumed to be due to the stress relaxation effect because the thermal expansion coefficient of each material of the stress relaxing interlayer is greater than that (0.5 ppm) of the glass and less than that of LT.

### Example 4

In a manner similar to that of Example 1, except that an interlayer having a thickness of about 1.0 µm and composed of SiO₂, was placed between the silicon substrate and the stress relaxing interlayer, a composite substrate was produced and under conditions similar to those of Example 1, a thermal shock test was carried out. The interlayer was formed on the silicon substrate by a CVD method and the stress relaxing interlayer was formed on the interlayer. The results are shown in Table 2 (LT on SiO₂ on Si).

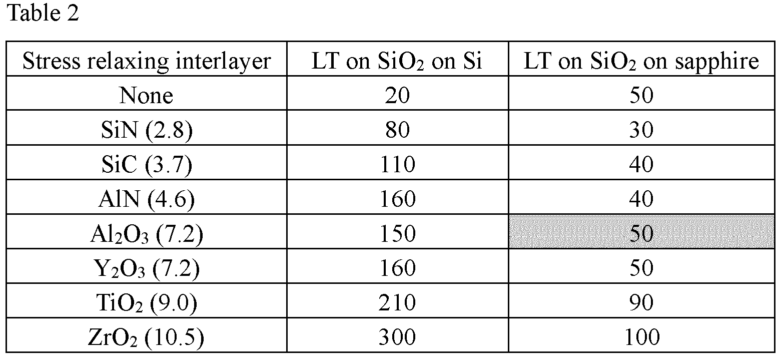

The results have revealed that any of the composite substrates having the stress relaxing interlayer between the interlayer and the LT thin film have improved reliability compared with the composite substrate having no stress relaxing interlayer. These results are presumed to be due to the stress relaxation effect, because the thermal expansion coefficient of each of the materials of the stress relaxing interlayer is greater than that (0.6 ppm) of SiO₂ as an interlayer and less than that of LT.

### Example 5

In a manner similar to that of Example 4 except for the use of a sapphire substrate instead of the silicon substrate, a composite substrate was produced and under conditions similar to those in Example 1, a thermal shock test was carried out. The results are shown in Table 2 (LT on SiO₂ on sapphire). These results have revealed that a composite substrate having the stress relaxing interlayer between the interlayer and the LT thin film has improved reliability only when the material of the stress relaxing interlayer has a thermal expansion coefficient greater than that of sapphire.

### Example 6

In a manner similar to that of Examples 1 to 5, except for the use of a lithium niobate (LN) substrate instead of the LN substrate as the oxide single-crystal substrate, a composite substrate was produced, and under conditions similar to those of Example 1, a thermal shock test was carried out. The thermal expansion coefficient of LN was 16 ppm and that of LN was 15 ppm. As a result, the composite substrate having the LN thin film and the composite substrate having the LT thin film showed the same tendency results.

### Example 7

In a manner similar to that of Examples 4 and 5 except for the use of SiON and SiN instead of SiO₂ as the material of the interlayer, a composite substrate was produced and under conditions similar to those of Example 1, a thermal shock test was carried out. The thermal expansion coefficient of SiON is about 2.0 ppm and that of SiN is 2.8 ppm. As a result, it has been found that as long as the stress relaxing interlayer was composed of a material having a thermal expansion coefficient greater than that of the interlayer, it was effective for providing a composite substrate having improved reliability, although the improvement degree varied.

### Example 8

In a manner similar to that of Examples 1 to 5 except that as the treatment for surfaces to be bonded, each of a vacuum ion beam method, an ozone water treatment method, and a UV ozone treatment method was performed instead of the plasma activation treatment, a composite substrate was produced and under conditions similar to those of Example 1, a thermal shock test was carried out. It has been revealed that the results were almost the same as those of Examples 1 to 5 and the stress relaxation effect did not depend on the treatment method for surfaces to be bonded.

### Example 9

In a manner similar to that of Examples 1 and 2 except that the LT substrate was thinned by implanting hydrogen ions in advance to the surface of the LT substrate to be bonded and releasing the laminate, which had been obtained by the bonding, along the implanted interface instead of grinding or polishing the laminate, a composite substrate was produced, and under conditions similar to those of Example 1, a thermal shock test was carried out. The LT thin film had a thickness of 0.8 µm. It was found that the results had the same tendency as those of Examples 1 and 2 and the stress relaxation effect did not depend on the thinning method of the LT substrate.

### Example 10

In a manner similar to that of Examples 1 and 4 except for the use of a PVD method instead of a CVD method as the method of forming the interlayer and the stress relaxing interlayer, a composite substrate was produced, and under conditions similar to those of Example 1, a thermal shock test was carried out. It was found that the results had the same tendency as those of Examples 1 and 4, and the stress relaxation effect did not depend on the method of forming the interlayer and the stress relaxing interlayer.

### REFERENCE SYMBOL LIST

- 1: Oxide single-crystal thin film
- 1A: Oxide single-crystal substrate
- 1X: Ion implantation layer
- 2: Supporting substrate
- 3: Stress relaxing interlayer
- 4: Interlayer
- 10, 20: Composite substrate

## Claims

1. A method for producing a composite substrate having a supporting substrate, a stress relaxing interlayer, and an oxide single-crystal thin film stacked in the listed order, comprising the steps of:
forming a stress relaxing interlayer between a supporting substrate and an oxide single-crystal substrate, the stress relaxing interlayer having a thermal expansion coefficient between that of the supporting substrate and that of the oxide single-crystal substrate;
bonding the supporting substrate and the oxide single-crystal substrate to each other with the stress relaxing interlayer therebetween to obtain a laminate; and
thinning the oxide crystal substrate of the laminate into an oxide crystal thin film.

2. A method for producing a composite substrate having a supporting substrate, an interlayer, a stress relaxing interlayer, and an oxide single-crystal thin film stacked in the listed order, comprising using a bonding method to satisfy the following inequation in comparison of a thermal expansion efficient: the interlayer < the stress relaxing interlayer < the oxide single-crystal thin film.

3. The method for producing a composite substrate according to claim 2, wherein the interlayer comprises SiO₂, SiON, or SiN.

4. The method for producing a composite substrate according to claim 2 or 3, wherein the interlayer is formed by a chemical vapor deposition method (CVD method) or a physical vapor deposition method (PVD method).

5. The method for producing a composite substrate according to any one of claims 1 to 4, wherein the stress relaxing interlayer comprises SiN, SiC, AlN, Al₂O₃, Y₂O₃, TiO₂, or ZrO₂.

6. The method for producing a composite substrate according to any one of claims 1 to 5, wherein the oxide single-crystal substrate comprises lithium tantalate (LT) or lithium niobate (LN).

7. The method for producing a composite substrate according to any one of claims 1 to 6, wherein the stress relaxing interlayer is formed by a chemical vapor deposition method (CVD method) or a physical vapor deposition method (PVD method).

8. The method for producing a composite substrate according to any one of claims 1 to 7, wherein the oxide crystal substrate of the laminate is thinned by grinding, polishing, or a combination thereof.

9. The method for producing a composite substrate according to any one of claims 1 to 8, further comprising subjecting a surface of the oxide single-crystal substrate to be bonded to an ion implantation treatment to form an ion implantation layer in the oxide single-crystal substrate,
wherein the oxide crystal substrate of the laminate is thinned by leaving the ion implantation layer as an oxide single-crystal thin film and releasing, from the laminate, a remaining portion of the oxide single-crystal substrate.

10. A composite substrate having a supporting substrate, a stress relaxing interlayer, and an oxide single-crystal thin film stacked in the listed order, wherein the stress relaxing interlayer has a thermal expansion coefficient between that of the supporting substrate and that of the oxide single-crystal thin film.

11. A composite substrate having a supporting substrate, an interlayer, a stress relaxing interlayer, and an oxide single-crystal thin film stacked in the listed order, wherein the stress relaxing interlayer has a thermal expansion coefficient between that of the interlayer and that of the oxide single-crystal thin film.

12. The composite substrate according to claim 11, wherein the interlayer comprises SiO₂, SiON, or SiN.

13. The composite substrate according to any one of claims 10 to 12, wherein the stress relaxing interlayer comprises SiN, SiC, AlN, Al₂O₃, Y₂O₃, TiO₂, or ZrO₂.

14. The composite substrate according to any one of claims 10 to 13, wherein the oxide single-crystal substrate comprises lithium tantalate (LT) or lithium niobate (LN).
